Europäisches Patentamt

**(19)** European Patent Office

Office européen des brevets

**(11)** Publication number : **0 320 285 B1**

**(12)** # EUROPEAN PATENT SPECIFICATION

**(45)** Date of publication of patent specification :
12.07.95 Bulletin 95/28

**(51)** Int. Cl.$^6$ : **H01F 7/20,** H01F 5/00

**(21)** Application number : **88311683.2**

**(22)** Date of filing : **09.12.88**

**(54)** Improvements in or relating to electrical coils.

**(30)** Priority : **11.12.87 GB 8729037**

**(43)** Date of publication of application :
**14.06.89 Bulletin 89/24**

**(45)** Publication of the grant of the patent :
**12.07.95 Bulletin 95/28**

**(84)** Designated Contracting States :
**DE FR NL**

**(56)** References cited :
**EP-A- 0 136 536**
**EP-A- 0 140 259**
**EP-A- 0 216 590**
**WO-A-86/04687**
**GB-A- 2 050 062**

**(56)** References cited :
**PATENT ABSTRACTS OF JAPAN vol. 12, no.
99 (E-594) 2946 31 March 1988, & JP-A-62
230009 (SHIMADZU CORP)
Acta Polytechnica Scandinavica Phys.Ser. no.
115, 1976, Helsinki, page 4 - 28;V.Kelha,L.Vir-
taperko: "Construction of demagnetizing coils
for beneficiationprocesses"**

**(73)** Proprietor : **BRITISH TECHNOLOGY GROUP
LIMITED
101 Newington Causeway
London SE1 6BU (GB)**

**(72)** Inventor : **Turner, Robert
5610 Oak Place
Bethesda Msryland 20817 (US)**

**(74)** Representative : **Davis, Norman Norbridge et
al
BRITISH TECHNOLOGY GROUP LTD
101 Newington Causeway
London SE1 6BU (GB)**

## Description

The present invention relates to electrical coils intended to generate magnetic fields and more particularly to a method of producing coils with a minimum inductance to produce a desired magnetic field and to the coils when so produced.

For many scientific purposes it is desirable to switch magnetic fields rapidly. For this reason coils generating these fields should have low inductance, since the switching time depends on L/R, where L is the inductance and R is the coil resistance.

Generally a specific variation of the magnetic field generated by the coil is required. Coil designers have usually been more concerned with ensuring a correct field distribution within the region of interest than with minimising the inductance, largely because calculation of the inductance was regarded as extremely difficult. The difficulty was such that the computation could not be performed in a systematic way, and hence it was not possible in most cases to show analytically that the inductance obtained was actually the minimum consistent with the desired coil performance.

Recently, however, a new formulation of the magnetic fields generated by currents confined to cylindrical shells has led to an attractively simple expression for the inductance of any coil formed on a cylinder. This expression lends itself, in conjunction with a variant on the target field approach described in co-pending British Published Patent Application No. 2193322, to the design of coils which accurately generate specified fields within a volume of interest, and which can have the absolute minimum inductance consistent with their performance.

European Patent Application Nos. 0140259 and 136536 describe the means of design and construction of coils of high quality and acknowledge that coil inductance is an important factor in such coil designs but do not provide any means for minimisation of coil inductance. In particular European Patent Application No. 136536 acknowledges the importance of coil induction on pages 19, 20, 25 and 26 and provides formula for its calculation but these formulae are not suitable for an explicit minimisation of the coil inductance while maintaining constant the gradient uniformity and coil efficiency.

European Patent Application No. 0140259 describes a method for etching employed on a thin conducting sheet so as to fabricate complicated magnetic coil patterns which are necessary to produce magnetic fields of high uniformity or other given design. A continuous current density distribution is calculated for providing a desired magnetic field and a thin line is etched in the thin conducting sheet along a streamline of the current distribution (see page 25). There is however, no formulae provided which are suitable for an explicit minimisation of the coil inductance while maintaining constant the gradient uniformity and coil efficiency.

It is an object of the present invention to provide a method of producing coils with minimum inductance and to build coils to those designs.

The present invention therefore provides a method of producing a coil or a set of coils to generate a given field per unit current at a finite set of specified points comprising the steps of positioning conductors of the coil on coaxial cylinders or parallel planes and supplying the conductors with such currents as to produce the given field per unit current at the said points, said positioning step and said supplying step being such as to ensure that the coil or set of coils have a minimum inductance consistent with the production of the said given field.

Preferably each point in the finite set of points is selected such that the field is specified within a known volume. In a particular embodiment a first number of the finite set of specified points are selected as being on the surface of an outer cylinder and the rest of the finite set of specified points are selected as being on the surface of an inner cylinder the field between the inner and outer cylindrical surfaces thereby being defined.

In a further embodiment a first number of the finite set of specified points are selected as being on a first plane and the rest of the rest of the finite set of specified points are selected as being on a second plane the field between the first and second planes being thereby defined.

Embodiments of the present invention will now be described, by way of example with reference to the accompanying drawings in which:-

Figure 1 shows a graph illustrating integrated current density on a cylinder of radius a with its axis in the z direction for a field specified to be the same at 10 points along the axis at equal spacings of 1/10th of the coil radius;

Figure 2 shows the coil layout for a first specified coil design;

Figure 3 shows the coil layout for a second specified coil design;

Figure 4 shows a first typical coil designed according to the present method;

Figure 5 shows a second typical coil designed according to the present method,

Figure 6 shows a first truncated coil designed according to the present invention; and

Figure 7 shows a second truncated coil designed according to the present invention.

## THEORETICAL EXPLANATION

Assume that the current generating the desired field is confined to the surface of a cylinder radius a. This assumption may be relaxed to include the case of current flowing in the wall of a thick cylinder, and the case of a screened coil (in which the coil is surrounded either by a thick conductive cylinder or by actively driven wire mimicking the effect of such a cylinder).

The current density is defined as $j(r,\phi,z)$ with components $j_\phi(r,\phi,z)$ in the azimuthal direction and $j_z(r,\phi,z)$ in the axial direction. As in the article TURNER R and BOWLEY R.M. (1986) "Passive switching of switched magnetic field gradients", J. Phys.E.Sci.Instru. 19,876 we define the Fourier transform of the current densities in the azimuthal and axial directions as:-

$$j_z^m (k) = \frac{1}{2\pi} \int_{-\pi}^{\pi} d\phi \, e^{-im\phi} \int_{-\infty}^{\infty} dz \, e^{-ikz} \, j_z(\phi,z) \qquad (1)$$

$$j_\phi^m(k) = \frac{1}{2\pi} \int_{-\pi}^{\pi} d\phi \, e^{-im\phi} \int_{-\infty}^{\infty} dz \, e^{-ikz} j_\phi(\phi,z) \qquad (2)$$

Here the axis of the cylinder is taken as the z direction and the azimuthal angle around this axis is taken as $\phi$.

Then the inductance of the coil may be written

$$L = - \frac{\mu_0 a^2}{I^2} \sum_{m=-\infty}^{\infty} \int_{-\infty}^{\infty} dk \, | j_\phi^m(k) |^2 \, I_m'(ka) \, K_m'(ka) \qquad (3)$$

where I is the current in each turn of the coil and a is the coil radius. The functions $I_m'(z)$ and $K_m'(z)$ are the modified Bessel functions. The axial component of the magnetic field is

$$B_z(r,\phi,z) = - \frac{\mu_0 a^2}{2\pi} \sum_{m=-\infty}^{\infty} \int_{-\infty}^{\infty} k \, dk \, j_\phi^m(k) e^{im\phi} e^{ikz} K_m'(ka) I_m'(kr)$$

$$(4)$$

For a screened coil, with screen radius b, the integrand in each of these expressions (3) and (4) must be multiplied by the factor S(a,b,k), where

$$S(a,b,k) = 1 - \frac{I_m'(ka)K_m'(kb)}{I_m'(kb)K_m'(ka)} \qquad (5)$$

Defining the normalised current density f=j/I, we may write the inductance as

$$L = -\mu_0 a^2 \sum_{m=-\infty}^{\infty} \int_{-\infty}^{\infty} dk \, | f_\phi^m(k) |^2 \, I_m'(ka) K_m'(ka) \qquad (6)$$

and the coil efficiency as

$$\frac{B_z(r,\phi,z)}{I} = -\frac{\mu_0 a}{2\pi} \sum_{m=-\infty}^{\infty} \int_{-\infty}^{\infty} k dk \, f_\phi^m(k) e^{im\phi} e^{ikz} K_m'(ka) I_m(kr)$$

$$(7)$$

where $B_z(r,\phi,z)$ is the axial magnetic field.

The desired magnetic field must be specified at a finite set of points lying on the surface of a cylinder, generally of radius much less than a. We write

$$B_z(r_n,\phi_n,z_n) = B_n \quad (8)$$

where n=1,2,.....,N.

We may now construct an expression involving Lagrange multipliers which enables the calculation of that current density distribution which minimises the coil inductance. We wish to minimise L subject to the condition (8). We define a function $U(f_\phi^m(k))$ by

$$U = L + \frac{1}{I} \sum_{n=1}^{N} \lambda_n (B_n - B_z(r,\phi,z)) \quad (9)$$

Where $B_n$ is the desired field and $B_z$ is the actual field at $r=(r_n,\phi_n,z_n)$.

Using functional differentiation, and assuming that $f_\phi^m$ is either pure real or pure imaginary, we find the condition for a minimum in U:

$$0 = \int_{-\infty}^{\infty} dk \left[ -2\mu_0 a^2 f_\phi^m(k) I_m'(ka) K_m'(ka) \right.$$

$$\left. + \sum_{n-1}^{N} \lambda_n \frac{\mu_0 3}{2\pi} ke^{im\phi_n} e^{ikz_n} K_m'(ka) I_m(kr_n) \right] \quad (10)$$

This has the solution

$$f_\phi^m(k) = \frac{k}{4\pi a I_m(ka)} \sum_{n=1}^{N} \lambda_n I_m(kr_n) e^{im\phi_n} e^{ikz_n} \quad (11)$$

Substituting back into (7) at the points at which the field is specified, we obtain

$$\frac{B_1}{I} = \frac{-\mu_0}{8\pi^2} \sum_{m=-\infty}^{\infty} \int_{\infty}^{\infty} k^2 dk \frac{K_m'(ka)}{I_m'(ka)} \sum_{n=t}^{N} \lambda_n I_m(kr_n) I_m(kr_1)$$

$$e^{im(\phi_n+\phi_1)} e^{ik(z_n+z_1)} \quad (12)$$

where again n=1,2,...,N; 1=f,2,....,N

This constitutes a set of N linear simultaneous equations in N unknowns, which may be solved easily using Gaussian elimination, to give a set of values for $\lambda$. The current density can then be evaluated explicitly using (11) and

$$j_\phi(\phi,z) = \frac{1}{2\pi} \sum_{m=-\infty}^{\infty} \int_{-\infty}^{\infty} e^{im\phi} e^{ikz} j_\phi^m(k) dk \quad (13)$$

All that is now required to produce a practical coil design is to approximate the continuous current density thus derived by a set of discrete wire arcs each carrying a current I. The method for achieving this is described in copending published UK Patent Applications Nos. 2180943 specifically in equations 49 and 51 on page 25 and 2193322; essentially each arc is placed along an equally spaced contour of the stream function in such a position that it carries the surface current from the areas on either side of it.

A similar analysis may be performed in the case of current confined to a plane or parallel planes. In the simplest useful case, here a purely azimuthal current is confined to two planed z= ±d, each of thickness 2c, the inductance can be written simply as :

$$L=\frac{\pi\mu_0}{I^2c}\int_0^\infty\frac{dk}{k}\left(1+\frac{\sinh(kc)\left[e^{-2kd}\sinh(kc)-e^{-kc}\right]}{kc}\right)|j_\phi(k)|^2 \qquad (14)$$

where the current density j(k) is now the Hankel transform of J(r)

$$j_\phi(k) = \int_0^\infty rdrJ_1(kr)j_\phi(r) \qquad (15)$$

where $J_1(z)$ is the Bessel function of the first order
The axial magnetic field may be written as :

$$B_z(r,\phi,z) = \mu_0 I\int_0^\infty kdkJ_c(kr)j_\phi(k)\frac{\sinh(kc)e^{-kd}}{kc}\cosh kz \qquad (16)$$

and again minimum inductance coil configurations may be derived. Of particular interest is a novel design for producing a uniform field, consisting of two pancake coils wound on parallel planes.

EXAMPLES

We will describe the three following examples of minimum inductance coils: a) solenoid, b) longitudinal gradient, and c) transverse gradient.

a) SOLENOID

In this case only the m=0 term is needed. The expressions (11) and (12) become

$$f_\phi(k) = \frac{1}{4\pi a}\frac{k}{I_1(ka)}\sum_{n=1}^N \lambda_n I_0(kr_n)e^{ikz_n} \qquad (17)$$

and

$$\frac{B_1}{I} = -\frac{\mu_0}{8\pi^2}\int_{-\infty}^\infty k^2dk\frac{K_1(ka)}{I_1(ka)}\sum_{n=1}^N\lambda_n e^{ik(z_n+z_1)} \qquad (18)$$

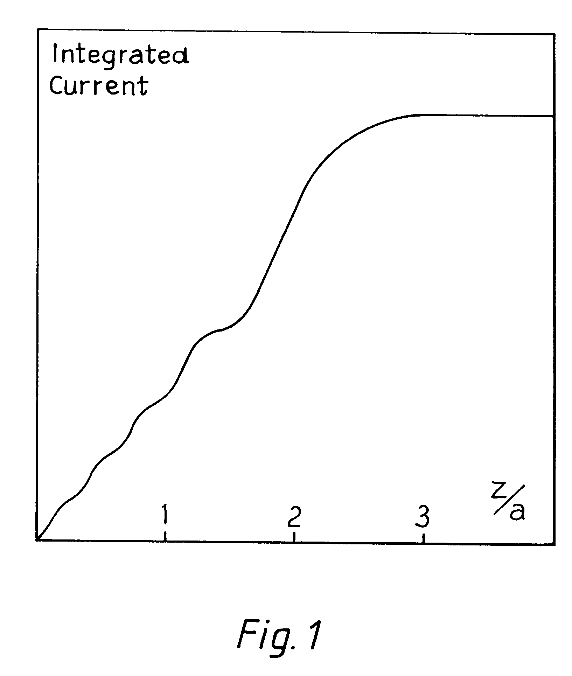

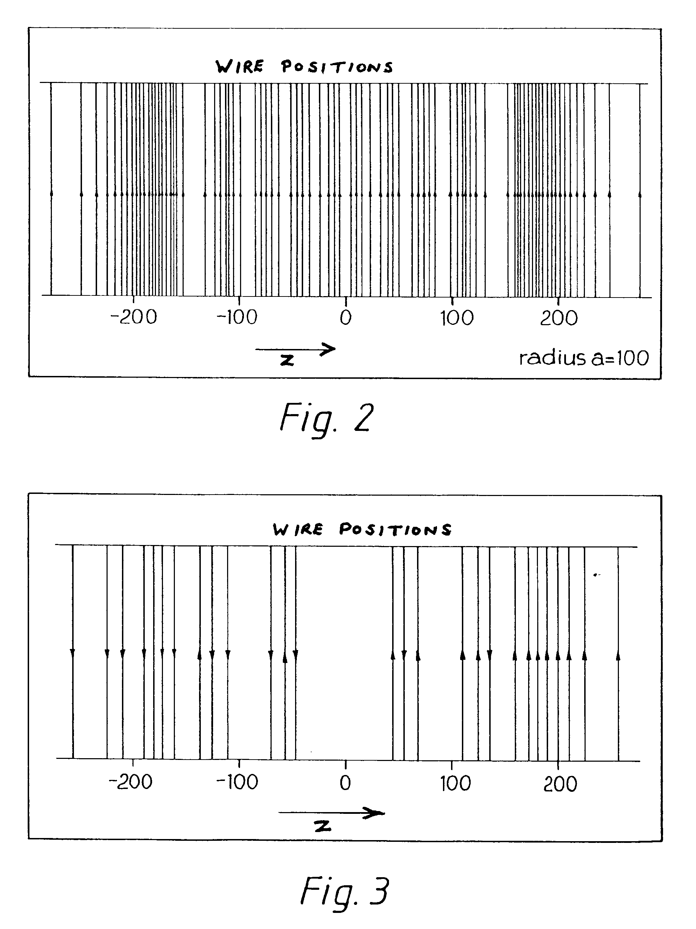

It is adequate to specify the field along the cylinder axis:
$$B_n = B_z(o,o,z_n) = B_o \qquad n = 1,2,....N \quad (19)$$
Alternatively the field may be specified on the central plane:
$$B_n = B_z(r_n,o,o) = B_o \qquad n = 1,2,....N \quad (20)$$
The example shown in Figure 1 shows the integrated current density distribution when the field is specified to be the same at 10 points along the axis, at equal spacings of 1/10th of the coil radius. Figure 2 shows the coil layout when 40 turns of 4 mm thick wire are used to approximate this current density. If the radius a=1m, the calculated inductance of this coil is 0.042H: the inductance of an Helmholtz pair giving the same axial homogeneity and current efficiency is 0.743H. The field produced by this coil design is precisely uniform at the points specified, and the homogeneity is better than 1 ppm for z <1.0a and r<0.6a.

b) LONGITUDINAL GRADIENT COIL

Here again only the m=0 term is needed. A little care must be taken to ensure that the current density derived has the required anti-symmetry about z=0; the Fourier sine transform is needed. Usually longitudinal gradient coils are specified to produce a magnetic field which is linear in z, and independent of r and $\phi$ out to a considerable fraction of the coil radius. The design shown in Figure 3 arises from a field specified as linear at 10 equally-spaced points along the axis, at separations 0.1a. It has an inductance of 377μH, compared with 8450μH for the conventional Maxwell pair giving the same efficiency and linearity, when a=1m and the wire thickness = 4 mm.

c) TRANSVERSE GRADIENT COIL

To obtain a uniform transverse gradient only the m=±1 terms are needed in the cylindrical harmonic expansion (4). This results in the following expressions for $B_z(r_1)$.

$$\frac{B_1}{I} = \frac{-\mu_0}{4\pi^2} \int_{-\infty}^{\infty} k^2 dk \frac{K_1(ka)}{I_1(ka)} \sum_{n=1}^{N} \lambda_n L_1(kr_n) I_1(kr_1) e^{ik(z_n+z_1)}$$

$$\times \cos(\phi_n+\phi_1) \qquad (21)$$

and $f_\phi^1(k)$

$$f_\phi^1(k) = \frac{1}{4\pi a} \frac{k}{I_1(ka)} \sum_{n=1}^{N} \lambda_n I_1(kr_n) e^{j\phi_n} e^{ikz_n} \qquad (22)$$

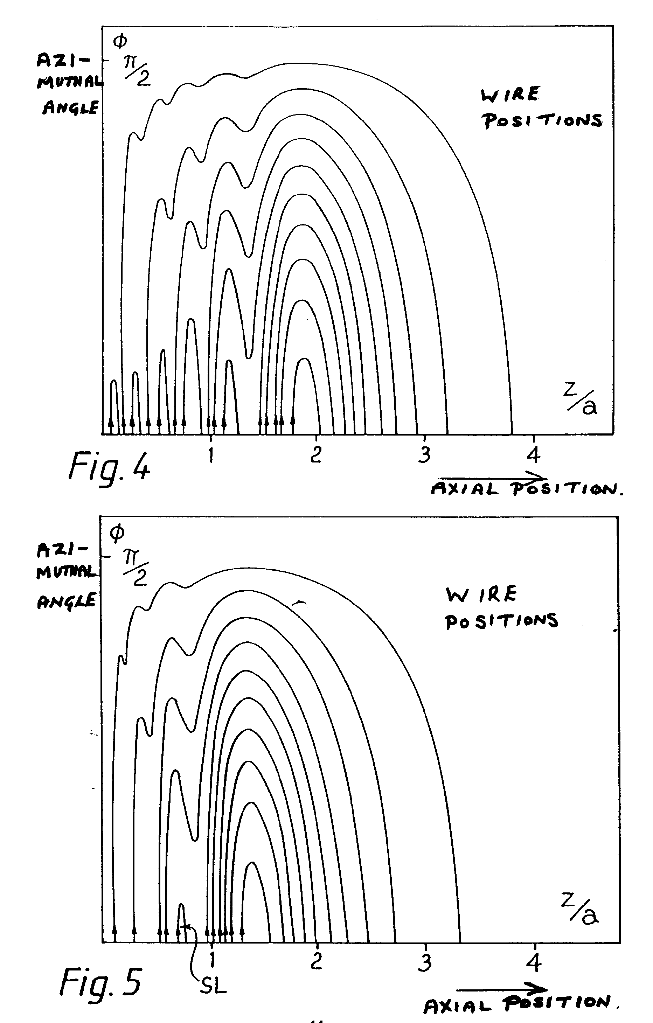

A typical coil design found by solving these, now using a field specified at ten points at $\phi$=0, r=0.01a and spaced by 0.1a in the z direction, is shown in Figure 4. A transverse gradient coil optimised for uniformity in the central plane, z=0, can also be derived, giving for example the design shown in Figure 5. This coil gives a transverse gradient uniform to 2% out to r=0.9a and z=±0.5a.

Small loops such as SL (Figure 5) can be eliminated in a systematic manner by multiplying the Fourier transform of current density (obtained by using procedures described hereinbefore) with the apodising function,

$$e^{-k^2t^2/2}$$

where t is a small distance chosen just large enough to eliminate the unnecessary undulations.

The resultant coil in general has a somewhat smaller inductance than the design prior to apodization, but this inductance is not the minimum consistent with producing exactly the required field at the selected points.

This simplified design sacrifices the desired field specification to a slight degree but leads to much simpler coil designs by eliminating small loops or rapid variation of turn spacing. The factor "t" has to be selected carefully, because as "t" is increased, conformity with the desired field specification at the selected points deteriorates. Typically t should be no more than a/10 (where a is the coil radius) which can give a coil producing the specified field at the selected points with an accuracy of 10 ppm.

We have described and illustrated a design principle which enables the construction of coils with the minimum inductance consistent with a given efficiency over a given volume. Of course all the coils shown have an actively-shielded counterpart, which may be derived simply by including the additional factor S(a,b,k) defined in equation (5). For purposes of rapid switching, as used in magnetic resonance imaging, it is hard to imagine how any further improvements in coil design strategy may be achieved.

In some circumstances it is necessary to restrict the length of a cylindrical coil. Using the minimum inductance formulation it is possible to design coils which have the lowest inductance consistent with an efficiency specified at a given number of points, while at the same time the coil is confined within a specified axial length. This constraint, that the current density is zero beyond a certain distance from the plane z=0, is introduced as a further set of Lagrange multipliers into equation (9), which becomes

$$U = L + \frac{1}{I} \sum_{n=1}^{N} \lambda_n \, (B_n - B_z(r_n, \phi_n, z_n)) + \frac{1}{I} \sum_{p=1}^{P} \nu_p \, j_\phi \, (\phi_p, z_p) \qquad (23)$$

where P is the number of points $(\phi_p, z_p)$ at which the current density is specified to be zero. We may write

$$j_f (\phi_p, z_p) = \frac{1}{2\pi} \sum_{m=-\infty}^{\infty} e^{im\phi_p} \int_{-\infty}^{\infty} dk \, e^{ikz_p} \, j_\phi^m (k) \qquad - \quad - \qquad (24)$$

and hence, taking the functional derivative of U as before, we obtain

$$0 = -2\mu_0 a^2 f_\phi^m (k) \, I_m'(ka) \, K_m'(ka) \qquad (25)$$

$$+ \sum_{n=1}^{N} \lambda_n \frac{\mu_0 a}{2\pi} k \, e^{im\phi_n} \, e^{ikz_n} K_m'(ka) \, I_m'(kr_n) + \sum_{p=1}^{P} \nu_p \, e^{im\phi_p} \, e^{ikz_p} \qquad - \quad -$$

So

$$f_\phi^m (k) = \frac{k}{4\pi a I_m'(ka)} \sum_{n=1}^{N} \lambda_n \, e^{im\phi_n} \, e^{ikz_n} \, I_m'(kr_n) \qquad (26)$$

$$+ \frac{1}{2\mu_0 a^2 I_m'(ka) \, K_m'(ka)} \sum_{p=1}^{P} \nu_p \, e^{im\phi_p} \, e^{ikz_p}$$

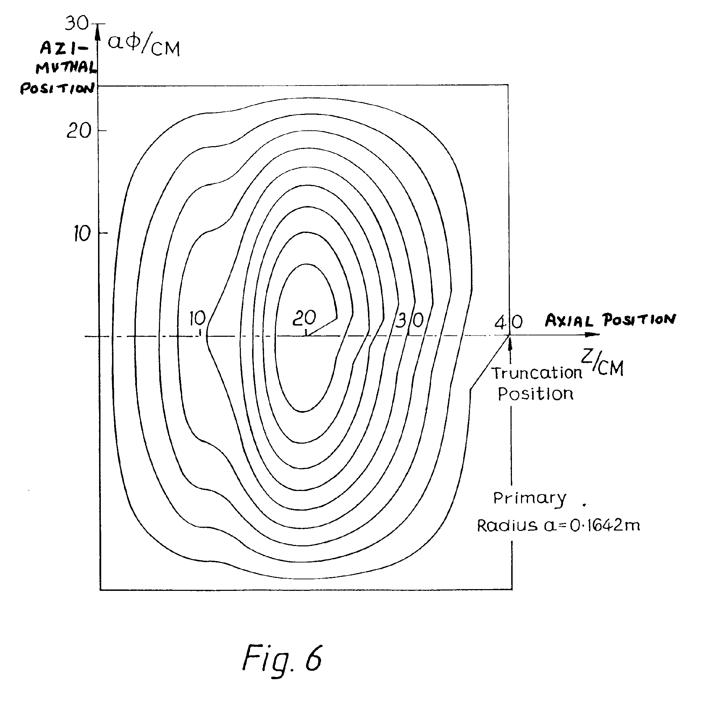

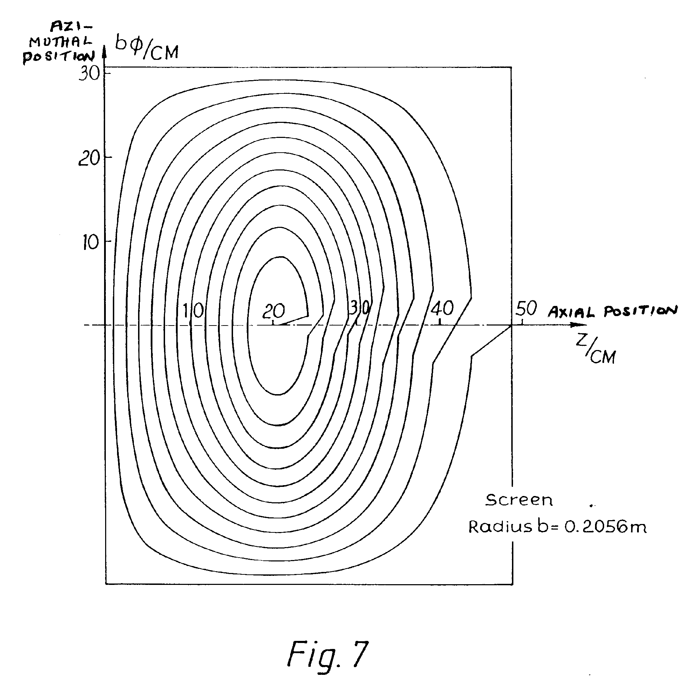

Using the argument presented earlier, we arrive at a set of N+P simultaneous equations in the N+P unknowns $\lambda_n$ and $\gamma_p$ which can again be solved by Gaussian elimination. The calculated current density is indeed zero at the points specified. In order to design an effective truncated coil it is only necessary to choose sufficiently many such points, sufficiently closely spaced, that the current density between them and beyond them remains substantially zero. For reasonable choices of coil parmeters transverse gradient coil designs are easily derived, as shown in the Figures 6 and 7 which respectively show primary and screen coil designs to achieve the desired current density distributions.

## Claims

1. A method of producing a coil or a set of coils to generate a given field per unit current at a finite set of specified points comprising the steps of positioning conductors of the coil on coaxial cylinders or parallel planes and supplying the conductors with such currents as to produce the given field per unit current at the said points, said positioning step and said supplying step being such as to ensure that the coil or set of coils have a minimum inductance (L) consistent with the production of the said given field,

    said method comprising the steps of:

    a)

    (i) calculating the Fourier transform $f_\phi^m(k)$ of the current density j confined to coaxial cylinders or parallel planes that minimizes the coil inductance L subject to the constraint that the magnetic field per unit current is as given at the finite specified points by means of functional differentiation of a function U(f(k)) in which

$$U \; = \; L = \frac{1}{I} \sum_{n=1}^{N} \lambda_n \; (B_n - B_z \; (r_n))$$

Where $B_n$ is the desired field, $B_z$ is the actual field expressed as a function of $f_\phi^m$ at the points $r_n = (r_n \phi_n, z_n)$, n = 1,2,3 - - N) at which the field is specified, I is the current in the coil, N is the total number of points at which the field is specified and $\lambda_n$, n = 1,2,3 - - N is a set of Lagrange Multipliers.

(ii) using functional differentiation, with respect to $f_\phi^m(k)$, finding a condition for a minimum in U;

b) calculating the continuous current density j from the Fourier transform $f_\phi^m(k)$,

c) approximating the continuous current density j by determining a set of positions for discrete wire arcs, and

d) placing the conductors in positions dictated by the positions of the set of discrete wire arcs.

2. A method of producing a coil as claimed in claim 1 in which each point in the finite set of points is selected such that the field is specified within a known volume.

3. A method of producing a coil as claimed in claim 2 in which a first number of the finite set of specified points are selected as being on the surface of an outer cylinder and the rest of the finite set of specified points are selected as being on the surface of an inner cylinder the field between the inner and outer cylindrical surfaces thereby being defined.

4. A method of producing a coil as claimed in claim 2 in which a first number of the finite set of specified points are selected as being on a first plane and the rest of the finite set of specified points are selected as being on a second plane the field between the first and second planes being thereby defined.

5. A method of producing a coil as claimed in claim 3 in which the coil is specified by a desired current density evaluated by the following expression.

$$j_\phi(\phi, z) \; = \; \frac{1}{2\pi} \sum_{m=-\infty}^{\infty} \int_{-\infty}^{\infty} e^{im\phi} e^{ikz} j_\phi^m(k) \, dk \qquad (13)$$

(in which $j_\phi(r,\phi,z,)$ are the components of current density in the azimuthal direction).

6. A method of producing a coil as claimed in claim 4 in which a purely azimuthal current is confined to two planes at z = ±d each of thickness 2c and in which the inductance is calculated from the following expression

$$L = \frac{\pi \mu_0}{I^2 c} \int_0^\infty \frac{dk}{k} \left(1 + \frac{\sinh(kc) \, [e^{-2kd} \sinh(kc) - e^{-kc}]}{kc}\right) |j_\phi(k)|^2 \qquad (14)$$

and wherein the current density j(k) is the Hankel transform of j(r) such that

$$j_\phi(k) \; = \; \int_0^\infty r \, dr J_1(kr) \, j_\phi(r) \qquad (15)$$

the axial magnetic field being

$$B_z(r, \phi, z) \; = \; \mu_0 I \int_0^\infty k \, dk J_c(kr) \, j_\phi(k) \, \frac{\sinh(kc) \, e^{-kd}}{kc} \cosh kz \qquad (16)$$

**Patentansprüche**

1. Verfahren zur Herstellung einer Spule oder eines Spulensatzes zur Erzeugung eines bestimmten Feldes pro Stromeinheit an einer endlichen Menge spezifizierter Punkte umfassend die Schritte des Positionierens der Stromleiter der Spulen auf koaxialen Zylindern oder parallelen Ebenen und Versorgen der Leiter mit Strömen, die das gewünschte Feld pro Stromeinheit an den besagten Punkten erzeugen, wobei der Positionierungsschritt und der Versorgungsschritt so ausgeführt werden, daß sichergestellt ist, daß die Spule oder der Spulensatz eine minimale Induktivität (L) aufweisen, die mit der Erzeugung des gewünschten Feldes vereinbar ist,
wobei das Verfahren die Schritte umfaßt:
   a)
   (i) Errechnen der Fourier-Transformation $f^m_\phi(k)$ der Stromdichte j, beschränkt auf die koaxialen Zylinder oder parallelen Ebenen, die die Spuleninduktivität L minimiert, unter der Bedingung, daß das Magnetfeld pro Stromeinheit dem an den endlichen spezifizierten Punken entspricht, ermittelt durch eine funktionale Ableitung einer Funktion U(f(k))

$$U \;=\; L \;=\; \frac{1}{I} \sum_{n=1}^{N} \lambda_n \, (B_n - B_z \, (r_n))$$

   wobei $B_n$ das gewünschte Feld, $B_z$ das tatsächliche Feld, ausgedrückt als eine Funktion von $f^m_\phi$ an den Punkten $r_n = (r_n \, \phi_n, \, Z_n)$, n = 1,2,3 - - N), an denen das Feld spezifiziert ist, I der Spulenstrom, N die Gesamtanzahl der Punkte, an denen das Feld spezifiziert ist und $\lambda_n$, n = 1,2,3 - - N ein Satz Lagrange-Multipilkatoren ist;
   (ii) Anwenden einer funktionalen Ableitung in bezug auf $f^m_\phi(k)$, Ermittlung einer Bedingung für ein Minimum von U;
   b) Errechnen der kontinuierlichen Stromdichte j aus der Fourier-Transformation $f^m_\phi(k)$,
   c) Schätzen der kontinuierlichen Stromdichte j durch Ermitteln eines Positionssatzes für diskrete Drahtbögen, und
   d) Plazieren der Leiter in Positionen, die durch die Positionen des Satzes diskreters Drahtbögen festgelegt sind.

2. Verfahren zur Herstellung einer Spule nach Anspruch 1, bei dem jeder Punkt des endlichen Punktesatzes so gewählt wird, daß das Feld innerhalb eines bekannten Volumens spezifiziert ist.

3. Verfahren zur Herstellung einer Spule nach Anspruch 2, bei dem eine erste Anzahl des endlichen Satzes spezifizierter Punkte so gewählt wird, daß sie auf der Oberfläche eines Außenzylinders liegt, wobei der Rest des endlichen Satzes der spezifizierten Punkte so gewählt wird, daß die Punkte auf der Oberfläche eines Innenzylinders liegen, wodurch das Feld zwischen den inneren und äußeren Zylinderoberflächen definiert wird.

4. Verfahren zur Herstellung einer Spule nach Anspruch 2, bei dem eine erste Anzahl des endlichen Satzes spezifizierter Punkte so gewählt wird, daß sie auf einer ersten Ebene liegt, wobei der Rest des endlichen Satzes der spezifizierten Punkte so gewählt wird, daß die Punkte auf einer zweiten Ebene liegen, wodurch das Feld zwischen der ersten und zweiten Ebene definiert wird.

5. Verfahren zur Herstellung einer Spule nach Anspruch 3, bei dem die Spule durch eine gewünschte Stromdichte, die durch die folgende Gleichung ermittelt wird, bestimmt ist:

$$j_\phi(\phi, z) \;=\; \frac{1}{2\pi} \sum_{n=-\infty}^{\infty} \int_{-\infty}^{\infty} e^{im\phi} e^{ikz} j_\phi^m(k)\, dk$$

$$(13)$$

(in der $j\phi(r, \phi, z,)$ die Komponenten der Stromdichte in Azimuthrichtung sind).

6. Verfahren zur Herstellung einer Spule nach Anspruch 4, bei dem ein rein azimuthaler Strom auf zwei Ebenen begrenzt ist, und zwar mit $z = \pm d$, je mit einer Dicke 2c, wobei die Induktivität aus der folgenden Glei-

chung errechnet wird

$$L=\frac{\pi\mu_0}{I^2c}\int_0^\infty\frac{dk}{k}\,(1+\frac{\sinh(kc)\,[e^{-2kd}\sinh(kc)-e^{-kc}]}{kc})\,|j_\phi(k)|^2 \qquad (14)$$

wobei die Stromdichte j(k) die Hankel-Transformation von j(r) ist, so daß

$$\tilde{j}_\phi(k) \;=\; \int_0^\infty r\,dr\,J_1(kr)\,j_\phi(r) \qquad\qquad (15)$$

und wobei das axiale Magnetfeld durch

$$B_z(r,\phi,z) \;=\; \mu_0 I\int_0^\infty k\,dk\,J_c(kr)\,j_\phi(k)\,\frac{\sinh(kc)\,e^{-kd}}{kc}\cosh kz \qquad (16)$$

gegeben ist.

## Revendications

1.  Procédé de fabrication d'une bobine ou d'un ensemble de bobines pour générer un champ donné par unité d'intensité en un ensemble fini de points spécifiés, comprenant les étapes consistant à mettre en place des conducteurs de la bobine sur des cylindres coaxiaux ou sur des plans parallèles et à alimenter les conducteurs avec des courants permettant de générer le champ donné par unité d'intensité auxdits points, ladite étape de mise en place et ladite étape d'alimentation servant à assurer que la bobine ou l'ensemble de bobines ont une inductance minimale (L) compatible avec l'obtention dudit champ donné,
    ledit procédé comprenant les étapes consistant à:
    a)
    (i) calculer la transformée de Fourier $f_\phi^m(k)$ de la densité j de courant, confinée à des cylindres coaxiaux ou des plans parallèles, ce qui miniminise l'inductance L de la bobine à condition que le champ magnétique par unité d'intensité soit le courant donné au niveau des points finis spécifiés, par différenciation fonctionnelle d'une fonction U(f(k)) dans laquelle

$$U \;=\; L \;=\; \frac{1}{I}\sum_{n=1}^{N}\ \lambda_n\ (B_n-B_z\ (r_n))$$

où $B_n$ est le champ voulu, $B_z$ est le champ réel exprimé en fonction de $f^m$ aux points $r_n = (r_n\phi_n,z_n)$, n = 1,2,3 - - N) auxquels est spécifié le champ, I est l'intensité dans la bobine, N est le nombre total de points auxquels est spécifié le champ et $\lambda_n$, n = 1,2,3 - - N est un ensemble de Multiplicateurs de Lagrange.
    (ii) en utilisant une différenciation fonctionnelle, par rapport à $f_\phi^m(k)$, trouver une condition pour un minimum dans U;
    b) calculer la densité continue j du courant à partir de la transformée de Fourier $f_\phi^m(k)$,
    c) s'approcher par approximation de la densité continue j du courant en déterminant un ensemble de positions pour des arcs de fils discrets, et
    d) placer les conductions dans les positions imposées par les positions de l'ensemble d'arcs de fils discrets.

2.  Procédé de fabrication de bobine selon la revendication 1, dans lequel chaque point de l'ensemble fini de points est choisi de façon que le champ soit spécifié dans un volume connu.

3.  Procédé de fabrication de bobine selon la revendication 2, dans lequel un premier nombre de points de l'ensemble fini de points spécifiés sont choisis comme étant sur la surface d'un cylindre extérieur et le reste des points de l'ensemble fini de points spécifiés sont choisis comme étant sur la surface d'un cylindre intérieur, le champ entre les surfaces cylindriques intérieure et extérieure étant de ce fait défini.

4. Procédé de fabrication de bobine selon la revendication 2, dans lequel un premier nombre de points de l'ensemble fini de points spécifiés sont choisis comme étant sur un premier plan et le reste des points de l'ensemble fini de points spécifiés sont choisis comme étant sur un second plan, le champ entre les premier et second plans étant de ce fait défini.

5. Procédé de fabrication de bobine selon la revendication 3, dans lequel la bobine est spécifiée par une densité de courant voulue évaluée par l'expression suivante.

$$j_\phi(\phi, z) = \frac{1}{2\pi} \sum_{m=-\infty}^{\infty} \int_{-\infty}^{\infty} e^{im\phi} e^{ikz} j^m(k) dk \qquad (13)$$

(où $j_\phi(r,\phi,z,)$ sont les composantes de densité de courant dans la direction azimutale.

6. Procédé de fabrication de bobine selon la revendication 4, dans lequel un courant purement azimutal est confiné dans deux plans en z=±d, chacun d'épaisseur 2c, et dans lesquels l'inductance est calculée d'après l'expression suivante:

$$L = \frac{\pi\mu_o}{I^2 c} \int_0^\infty \frac{dk}{k} \left(1 + \frac{\sinh(kc) [e^{-2kd}\sinh(kc) - e^{-kc}]}{kc}\right) |j_\phi(k)|^2 \qquad (14)$$

et où la densité j(k) du courant est la transformée de Hankel de j(r) de telle façon que

$$j_\phi(k) = \int_0^\infty r dr J_1(kr) j_\phi(r) \qquad (15)$$

le champ magnétique axial étant

$$B_z(r,\phi,z) = \mu_o I \int_0^\infty k dk J_c(kr) j_\phi(k) \frac{\sinh(kc) e^{-kd}}{kc} \cosh kz \qquad (16)$$

Fig. 1

Fig. 2

Fig. 3

AZI-
MUTHAL
ANGLE

$\phi$

$\frac{\pi}{2}$

WIRE
POSITIONS

$z/a$

1    2    3    4

*Fig. 4*

AXIAL POSITION.

AZI-
MUTHAL
ANGLE

$\phi$

$\frac{\pi}{2}$

WIRE
POSITIONS

$z/a$

1    2    3    4

*Fig. 5*

SL

AXIAL POSITION.

*Fig. 6*

Fig. 7